# EUROPÄISCHE PATENTSCHRIFT

(11) **EP 0 514 381 B1**
(45) Veröffentlichungstag und Bekanntmachung des Hinweises auf die Patenterteilung: **03.11.1993**
(21) Anmeldenummer: 91901543.8
(22) Anmeldetag: 18.12.1990
(51) Int. Cl.: G05F 1/56, H03F 3/347

(54) **FREQUENZGANGKOMPENSIERTE SCHALTUNG**
FREQUENCY RESPONSE-COMPENSATED CIRCUIT
CIRCUIT A COMPENSATION DE LA REPONSE FREQUENTIELLE

(30) Priorität: 10.02.1990 DE 4004135
(43) Veröffentlichungstag der Anmeldung: 25.11.1992
(73) Patentinhaber: Deutsche Thomson-Brandt GmbH, 78003 Villingen-Schwenningen (DE)
(72) Erfinder: KOBLITZ, Rudolf, W-7730 Villingen (DE); LEHR, Steffen, W-7730 VS Marbach (DE)
(74) Vertreter: Einsel, Robert, Dipl.-Ing.
(86) Internationale Anmeldenummer: EP9002221
(87) Internationale Veröffentlichungsnummer: WO9112573

(56) Entgegenhaltungen:
- FR-A- 2 476 936
- US-A- 3 582 689
- US-A- 3 984 780
- US-A- 4 028 631

## Beschreibung

Die Erfindung betrifft eine frequenzgangkompensierte Schaltung in Regelschleifen.

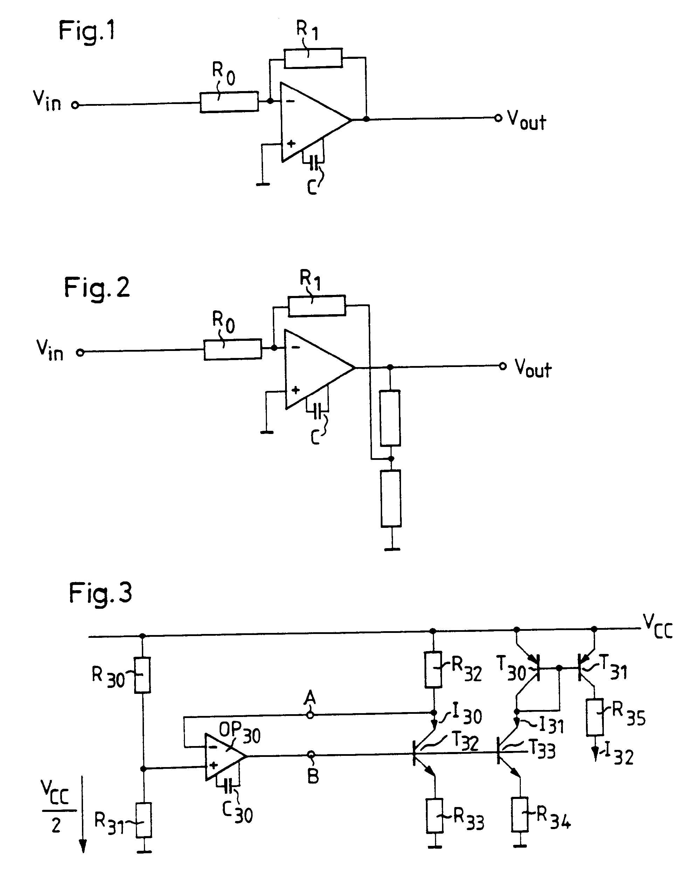

Die Gleichspannungsverstärkung eines Operationsverstärkers, der gemäß Fig. 1 beschaltet ist, ergibt sich zur Vₒᵤₜ = Vᵢₙ * R₁ / R₀. Intern besteht ein solcher integrierter Operationsverstärker hauptsächlich aus Transistoren und Widerständen. Zwischen den Verbindungsleitungen und Basis, Kollektor, Emitter der Transistoren und dem Substrat (= Masse) bestehen kapazitive Kopplungen, sogenannte parasitäre Kapazitäten.

Diese parasitären Kapazitäten bewirken in Richtung höherer Frequenzen eine zunehmende Gegenkopplung, so daß die Verstärkung gegenüber der Gleichspannungsverstärkung immer mehr abnimmt. Entsprechend ändert sich mit zunehmender Frequenz auch der Phasengang. Ab einer bestimmten Frequenz, z.B. 10 MHz, ist die Phasenverschiebung größer als 180°. Weil die Verstärkung aber immer noch größer als 1 ist, kommt es dann zu unkontrollierten Schwingungen.

Um diese Schwingungen zu verhindern, fügt man an geeigneter Stelle im Operationsverstärker einen Kondensator zur Frequenzgangkompensation ein. Dadurch bleibt die Phasenverschiebung innerhalb eines bestimmten Frequenzbereiches bei - 90°, während die Verstärkung mit größerer Steilheit abnimmt. Wenn die Phasenverschiebung bei höheren Frequenzen schließlich - 180° erreicht, ist die Verstärkung bereits kleiner als 1 und es treten keine störenden Schwingungen mehr auf.

Je größer die Verstärkung ist, desto stärker muß der Frequenzgang kompensiert werden. In integrierten Schaltungen benötigt ein Kondensator (zur Frequenzgangkompensation) aber eine relativ große Chipfläche, z.B. 0,001 mm²/pF. Für einen Kondensator von 1000 pF wäre demnach eine Fläche von 1 mm² notwendig.

In US-A-3,984,780 ist eine mit einem Kondensator frequenzgangkompensierte Regelschaltung angegeben. Um eine hohe Regelgenauigkeit zu erreichen, muß die interne Verstärkung und damit auch der Kondensator groß sein.

Der Erfindung liegt die Aufgabe zugrunde, durch eine Regelschaltung genaue Ströme zu erzeugen und die erforderliche Kapazität des Frequenzgang-Kompensations-Kondensators in der Regelschaltung zu verkleinern.

Diese Aufgabe wird durch die in Anspruch 1 angegebenen Merkmale gelöst. Vorteilhafte Weiterbildungen der Erfindung sind in den Unteransprüchen angegeben.

Anhand der Zeichnungen wird im folgenden ein Ausführungsbeispiel der Erfindung erläutert. Es zeigt:
- Fig. 1: Beschaltung eines Operationsverstärkers (bekannt)
- Fig. 2: Beschaltung eines Operationsverstärkers mit reduzierter Gegenkopplung (bekannt)
- Fig. 3: Schaltung zur Erzeugung eines genauen Stromes mit einem Operationsverstärker in der Regelschleife (bekannt)
- Fig. 4: Schaltung zur Erzeugung eines näherungsweise genauen Stromes (bekannt)
- Fig. 5: erfindungsgemäße Schaltung zur Erzeugung eines genauen Stromes
- Fig. 6: Darstellung eines Regelkreises (bekannt)
- Fig. 7: Darstellung eines erfindungsgmäßen Regelkreises
- Fig. 8: Schaltbild einer temperaturkompensierten Stromversorgung.

In Fig. 1 ist die Beschaltung eines gegengekoppelten Operationsverstärkers dargestellt. Die Verstärung ergibt sich zu Vₒᵤₜ = Vᵢₙ * R₁ / R₀.

In Fig. 2 ist die Beschaltung eines gegengekoppelten Operationsverstärkers mit reduzierter Gegenkopplung dargestellt. C ist jeweils der Kondensator für die Frequenzgangkompensation.

In Fig. 3 haben R₃₀ und R₃₁ den gleichen Widerstandswert. Weil der daran angeschlossene, nicht invertierende Eingang des Operationsverstärkers OP₃₀ im Vergleich dazu hochohmig ist, entsteht über R₃₀ und R₃₁ jeweils die halbe Versorgungsspannung V_{CC} R₃₂ ist ein Referenzwiderstand mit einem Widerstandswert von z.B. 50 kOhm. Transistor T₃₀ bildet einen Stromspiegel. Der Verbindungspunkt von R₃₂, Kollektor von Transistor T₃₂ ist an den invertierenden Eingang von Operationsverstärker OP₃₀ angeschlossen. Dadurch fließt in den Kollektor von T₃₂ ein Referenzstrom I₃₀ = (V_{CC} / 2) / R₃₂. An Kollektor von Transistor T₃₃ bildet sich der gleiche Strom I₃₁ = I₃₀. Durch die Stromspiegelfunktion von T₃₀ und den Widerstand R₃₅ bildet sich durch R₃₅ ein Strom I₃₂ = (R₃₅ / R₃₂) * (V_{CC} / 2) / R₃₂.
Der Kondensator C₃₀ am Operationsverstärker OP₃₀ dient zur Frequenzgangkompensation der Regelung des Referenzstromes I₃₀. C₃₀ muß einen relativ großen Wert haben und benötigt darum viel Chip-Fläche. Die Ströme I₃₀, I₃₁, I₃₂ sind abhängig von der Versorgungsspannung V_{CC}. Weil V_{CC} sehr genau sein kann, sind auch die Ströme I₃₀ bis I₃₂ entsprechend genau.

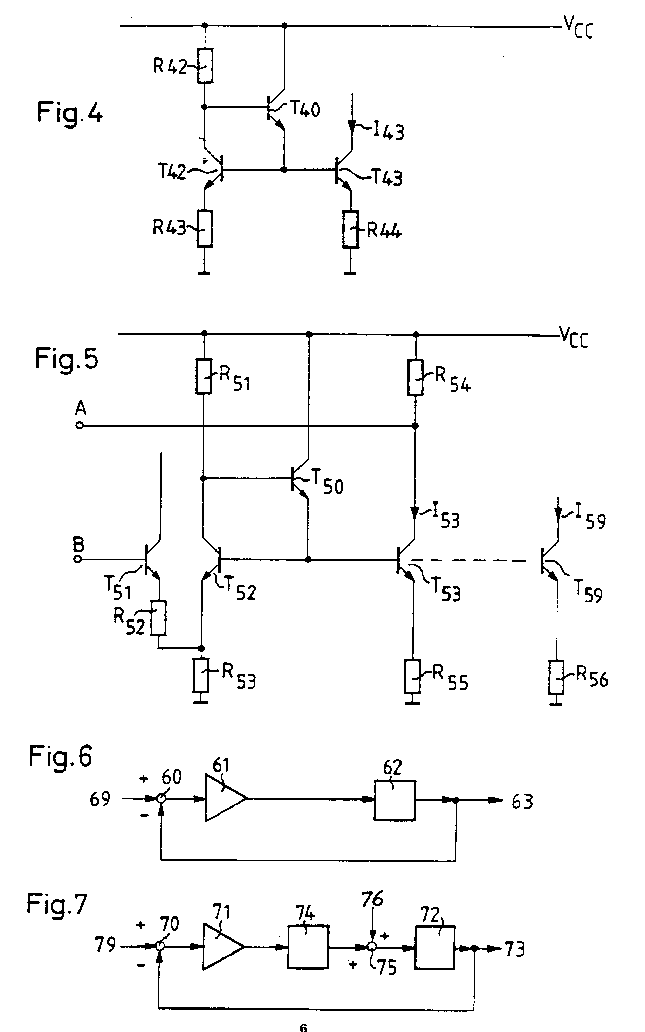

Fig. 4 zeigt eine weitere Schaltung, die genaue Ströme erzeugen soll. R₄₂ ist ein entsprechender Referenzwiderstand und T₄₀ ein Stromspiegel. Der Strom I₄₃ ergibt sich zu I₄₃ = (V_{CC} - 2 * V_{BE}) / R₄₂. Weil die Basis-Emitter-Spannung V_{BE} temperaturabhängig ist, ist der Strom I₄₀ ebenfalls temperaturabhängig. Im Bereich von 0 .... 100° C ändert sich V_{BE} um etwa 200 mV. Andererseits ist aber der Schaltungsaufwand gegenüber Fig. 3 deutlich geringer. Insbesondere wird die relativ große Chip-Fläche für den Kondensator C₃₀ eingespart.

Fig. 5 zeigt nun eine Schaltung, die genaue Ströme erzeugt, bei der aber die Chipfläche für einen Frequenzgangkompensations-Kondensator deutlich reduziert ist. An die Anschlußpunkte A und B wird die in Fig. 3 links von A und B liegende Schaltung, bestehend aus den Widerständen R₃₀ und R₃₁, dem Operationsverstärker OP₃₀ und dem Kondensator C₃₀, angeschlossen. R₅₁ und R₅₄ haben den gleichen Wert und sind Referenzwiderstände. T₅₀ ist ein Stromspiegel. I₅₃ ist der Referenzstrom. An weiteren Transistoren, z.B. T₅₉, deren Basisanschlüsse an die Basis von T₅₃ angeschlossen sind, bilden sich weitere, exakt gleiche Referenzströme, z.B. I₅₉. In Fig. 5 entsprechen die Widerstände R₅₁, R₅₃, R₅₅ den Widerständen R₄₂, R₄₃, R₄₄ aus Fig. 4 und die Transistoren T₅₀, T₅₂, T₅₃ den Transistoren T₄₀, T₄₂, T₄₃ aus Fig. 4. Dadurch wird der Referenzstrom I₅₃ praktisch entsprechend dem Referenzstrom I₄₃ vorgeregelt. Die Feinregelung übernimmt der an den Anschlußpunkten A und B angeschlossene Operationsverstärker OP₃₀. OP₃₀ muß nur noch die durch V_{BE} bedingten temperaturabhängigen Schwankungen nachregeln. Entsprechend kann der Regelbereich von OP₃₀ und damit die Gegenkopplung (wie für Fig. 2 beschrieben) verringert werden. Dies geschieht dadurch, daß der Ausgang von OP₃₀ nicht direkt an den Emitter von T₅₂ angeschlossen wird, sondern über den Emitterfolger T₅₁ und einen Widerstand R₅₂. Der Widerstand R₅₂ hat z.B. den Wert R₅₂ = 10 * R₅₃ Entsprechend kann C₃₀ um den Faktor 10 verkleinert werden und z.B. statt 50 pF einen Wert von 5 pF haben.
Drei Transistoren und drei Widerstände benötigen z.B. eine Chip-Fläche, die der Fläche für einen 2 pF-Kondensator entsprechen würde. Man erkennt, daß durch die Reduktion von 50 pF auf 5 pF trotz der gegenüber Fig. 3 erhöhten Anzahl von Bauelementen eine deutliche Reduktion der benötigten Chip-Fläche für die gesamte Regelschaltung erfolgt, obwohl die Genauigkeit des Referenzstroms I₅₃ dem von I₃₀ entspricht.

In Fig. 6 und Fig. 7 ist das Prinzip der Erfindung nochmals verdeutlicht. Fig. 6 zeigt einen bekannten Regelkreis. Der Sollwert 69 wird einem Subtraktionspunkt 60 zugeführt. Vom Sollwert 69 wird der Istwert 63 abgezogen. Das Ergebnis wird über einen Fehlerverstärker 61 der Regelstrecke 62 zugeführt, die als Ausgangssignal den Istwert liefert.

Fig. 7 zeigt einen Regelkreis gemäß der Erfindung. Der Sollwert 79 wird einem Subtraktionspunkt 70 zugeführt. Vom Sollwert 79 wird der Istwert 73 abgezogen. Das Ergebnis wird über einen Fehlerverstärker 71 und einen Multiplizierer 74 einem Additionspunkt 75 zugeführt. Dort wird ein Voreinstellungs-Steuerwert 76 addiert und die Summe der Regelstrecke 72 zugeführt, die als Ausgangssignal wieder den Istwert liefert. Durch die Addition des Voreinstellungssteuerwertes 76 kann die Fehlerverstärkung 71 reduziert werden. Dies geschieht durch Multiplikation mit einem Übertragungswert k, k < 1, z.B. k = 0,1 ... 0,5 , im Multiplizierer 74. Durch die Reduktion der Fehlerverstärkung kann vorteilhaft die Frequenzgangkompensation im Fehlerverstärker 71 um den Faktor 1 / k verringert werden.

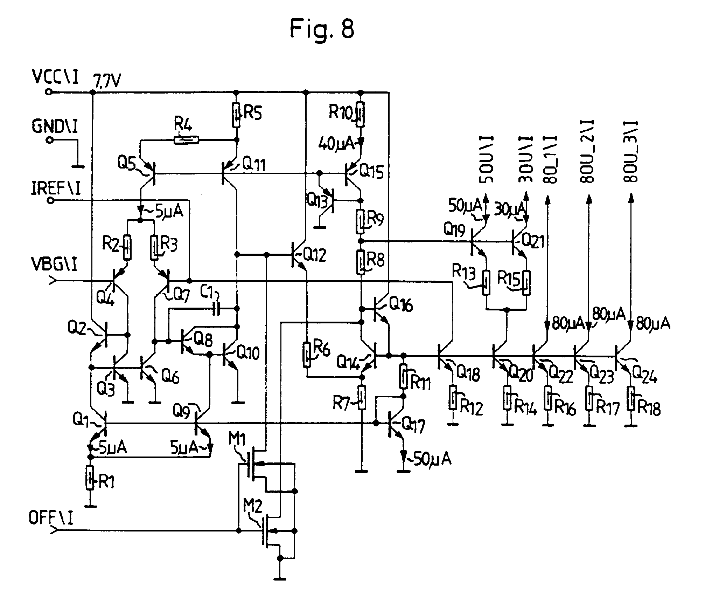

Die Schaltung nach Fig. 8 liefert an den Ausgängen 80_1\I, 80U_2\I und 80U_3\I jeweils einen Strom von 80 µA, am Ausgang 50U\I einen Strom von 50 µA und am Ausgang 30U\I einen Strom von 30 µA.

Zwischen den Anschlüssen VCC\I und IREF\I wird ein Referenzwiderstand angeschlossen. Wenn dieser Widerstand nicht mitintegriert ist, muß die Temperaturkompensation für die V_{BE}- Schwankungen etwas verstärkt werden. Der Übertragungswert k wird dann auch entsprechend etwas größer. Q₁₂ entspricht T₅₁, R₆ entspricht R₅₂, R₈/R₉ entsprechen R₅₁, Q₁₆ entspricht T₅₀, Q₁₄ entspricht T₅₂, R₇ entspricht R₅₃, der Referenzwiderstand entspricht R₅₄, Q₁₈ entspricht T₅₃, R₁₂ entspricht R₅₅, Q₂₄ und R₁₈ entsprechen T₅₉ und R₅₆.
Die Basisanschlüsse von Q₄ und Q₇ entsprechen den Eingängen von OP₃₀, die Kollektoranschlüsse von Q₁₀ und Q₁₁ dem Ausgang von OP₃₀ und der Kondensator C₁ dem Kondensator C₃₀.

Anschluß GND\I ist der Masseanschluß. An Anschluß VBG\I wird eine Referenzspannung von 1,2 V angeschlossen und mit Anschluß OFF\I werden die obengenannten Ausgänge geschaltet.

Q₁₂, Q₁₄, Q₁₆, R₆, R₈ und R₉ sind gegenüber einer Schaltung entsprechend Fig. 3 zusätzlich vorhanden. Insgesamt wird aber durch die Verkleinerung von C₁ eine deutlich größere Chip-Fläche eingespart, wie oben beschrieben.

## Patentansprüche

1. Frequenzgangkompensierte Schaltung mit einem der Schaltung zugeführten Sollwert (79) und mit einem in der Schaltung erzeugten Istwert (73), die eine gegenkoppelte Verstärkung (71, OP30) mit mindestens einem Kondensator (C₁, C30) beinhaltet, wobei diese Verstärkung kleiner als eins ist, wenn der entsprechende Phasengang den Betrag von 180° erreicht, und wobei dieser Verstärkung ein Steuerwert (IREF, Basis Q₇; 73-70) als zweite Gegenkopplung aufgeschlagen wird, der von dem Istwert abgeleitet ist, **dadurch gekennzeichnet**, daß dem Ausgangssignal (Strom durch R₆) der gegengekoppelten Verstärkung zusätzlich ein ungeregelter Steuerwert (76, Emitterstrom von Q₁₄) aufgeschlagen wird, wobei ein reduzierter Anteil (74; R₆, R₇; R₅₂, R₅₃) des mit dem ungeregelten Steuerwert kombinierten Ausgangssignals der gegengekoppelten Verstärkung den Istwert (73) bildet.

2. Frequenzgangkompensierte Schaltung nach Anspruch 1, **dadurch gekennzeichnet,** daß der ungeregelte Steuerwert (76) abgeleitet ist von mindestens einer Versorgungsspannung (V_{CC}, VCC\I) der Schaltung, von mindestens einem Referenzwiderstand (R₅₁, R₅₄; R₈, R₉) und von mindestens einer Basis Emitter-Spannung (V_{BE}).

3. Frequenzgangkompensierte Schaltung nach Anspruch 1 oder 2, **dadurch gekennzeichnet**, daß die gegengekoppelte Verstärkung (71) einen Operationsverstärker zur Fehlersignal-Verstärkung enthält.

4. Frequenzgangkompensierte Schaltung nach Anspruch 3, **dadurch gekennzeichnet,** daß der Operationsverstärker den Kondensator (C₁) zur Phasengang-Änderung enthält.

## Claims

1. A frequency-response-compensated circuit with a desired value (79) which is supplied to the circuit and with an actual value (73) which is produced in the circuit, which circuit comprises a negative feedback amplification stage (71, OP30) with at least one capacitor (C₁, C30), where this amplification is smaller than one when the corresponding phase response attains 180°, and where a control value (IREF, base Q₇; 73-70) derived from the actual value is added to this amplification as a second negative feedback, characterised in that an unregulated control value (76, emitter current of Q₁₄) is added to the output signal (current through R₆) of the negative feedback amplification stage, where a reduced component (74; R₆, R₇; R₅₂, R₅₃) of the output signal of the negative feedback amplification stage, combined with the unregulated control value, forms the actual value (73).

2. A frequency-response-compensated circuit as claimed in Claim 1, characterised in that the unregulated control value (76) is derived from at least one supply voltage (V_{CC}, VCC\I) of the circuit, from at least one reference resistance (R₅₁, R₅₄; R₈, R₉) and from at least one base-emitter voltage (V_{BE}).

3. A frequency-response-compensated circuit as claimed in Claim 1 or 2, characterised in that the negative feedback amplification stage (7) contains an operational amplifier for error signal amplification.

4. A frequency-response-compensated circuit as claimed in Claim 3, characterised in that the operational amplifier contains the capacitor (C₁) for changing the phase response.

## Revendications

1. Circuit à compensation de réponse fréquentielle avec une valeur de consigne (79) amenée au circuit et avec une valeur effective (73) produite dans le circuit qui comprend une amplification à contre-réaction (71, OP30) avec au moins un condensateur (C₁, C30) , cette amplificateur étant inférieure à un lorsque la réponse phase correspondante atteint la valeur de 180° et une valeur de commande (IREP, base Q₇ ; 73-70) étant amenée à cette amplification comme seconde contre-récation, cette valeur étant dérivée de la valeur effective, **caractérisé en ce** qu'une valeur de commande non réglée (76, courant d'émetteur de Q₁₄) est amenée en plus au signal de sortie (courant par R6) de l'amplification à contre-réaction, une partie réduite (74 ; R₆, R₇ ; R₅₂, R₅₃) du signal de sortie combiné à la valeur de commande non réglée de l'amplification à contre-réaction formant la valeur effective (73).

2. Circuit à compensation de réponse fréquentielle selon la revendication 1, **caractérisé en ce** que la valeur de commande non réglée (76) est dérivée d'au moins une tension d'alimentation (V_{CC}, V_{CC}\I) du circuit, d'au moins une résistance de référence (R₅₁, R₅₄ ; R₈, R₉) et d'au moins une tension base-émetteur (V_{BE}).

3. Circuit à compensation de réponse fréquentielle selon la revendication 1 ou 2, **caractérisé en ce** que l'amplification à contre-réaction (71) contient un amplificateur opérationnel pour l'amplification du signal d'erreur.

4. Circuit à compensation de réponse fréquentielle selon la revendication 3, **caractérisé en ce** que l'amplificateur opérationnel contient le condensateur (C1) pour le changement de la réponse phase.
